# EUROPEAN PATENT APPLICATION

(11) **EP 1 439 588 A2**
(43) Date of publication of application: **21.07.2004**
(21) Application number: 03079143.8
(22) Date of filing: 19.12.2003
(51) Int. Cl.: H01L 51/20

(54) **Organic light emitting diode (OLED) display with improved light emission using a metallic anode**

(30) Priority: 17.01.2003 US 347013
(71) Applicant: EASTMAN KODAK COMPANY, Rochester, New York 14650 (US)
(72) Inventor: Raychaudhuri, Pranab K., Rochester, New York 14650-2201 (US); Madathil, Joseph K., Rochester, New York 14650-2201 (US); Shore, Joel D., Rochester, New York 14650-2201 (US)
(74) Representative: Weber, Etienne Nicolas

(57) **Abstract**

OLED devices, suitable for top and bottom emitters is disclosed. For the top emitting OLED it includes a transparent substrate; a reflective, weakly absorbing, and conductive anode layer including a metal or metal alloy or both formed over the substrate; a hole-injection layer; a plurality of organic layers formed over the hole-injection layer and including an emissive layer having electroluminescent material and an electron transport layer disposed over the emissive layer; a reflective and conductive cathode including a metal or metal alloy or both provided over the electron transport layer; and the transparency and reflectivity of the anode structure, reflectivity of cathode structure, and the thickness of the organic layers between the electrodes being selected to change the internal reflection of light to thereby improve the emission and obtain luminance through-substrate exceeding that of an optimized control device not having the reflective, weakly absorbing, and conductive anode.

## Description

The present invention relates to enhanced bottom-emitting and highly efficient top-emitting organic light emitting device (OLED) devices, which use a metallic anode.

An organic electroluminescent (OEL) device, alternately known as organic light emitting diode (OLED), is useful in flat-panel display applications. This light-emissive device is attractive because it can be designed to produce red, green, and blue colors with high luminance efficiency; it is operable with a low driving voltage of the order of a few volts and clearly viewable from oblique angles. These unique attributes are derived from a basic OLED structure comprising of a multilayer stack of thin films of small-molecule organic materials sandwiched between an anode and a cathode. Tang and others in commonly-assigned US-A-4,769,292 and US-A-4,885,211 have disclosed such a structure. The common electroluminescent (EL) medium is comprised of a bilayer structure of a hole-transport (HTL) layer and an electron-transport layer (ETL), typically of the order of a few tens of nanometer (nm) thick for each layer. When an electrical potential difference is applied at the electrodes, the injected carriers -hole at the anode and electron at the cathode- migrate towards each other through EL medium and a fraction of them recombine to emit light. The intensity of electroluminescence is dependent on the EL medium, drive voltage, and charge injecting nature of the electrodes. The light viewable outside of the device is further dependent on the design of the organic stack and optical properties of the substrate, anode and the cathode.

Conventional devices are bottom emitting as the emitted light passes through the bottom support over which all the layers are deposited. The devices normally employ glass substrates having a layer of highly transparent indium-tin-oxide (ITO) layer that also serves as the anode. The cathode is typically a reflective thin film of MgAg although lithium-containing alloys are also known to provide efficient electron injection. The light is emitted in all directions. The light emitted toward the substrate passes through the anode and the substrate to the viewer, and the light emitted in the opposite direction is reflected at the cathode and passes through the substrate, enhancing the bottom-emission. A high transparency substrate and anode and a high reflectivity cathode are employed in high efficiency devices. High-efficiency displays are especially desirable because of their low power consumption. Furthermore these displays are operable at low drive current enhancing their operational life. The conventional bottom-emitting device engineering is nearly matured. In general up to 80% of generated light is not available for viewing due to losses in waveguiding modes in glass, ITO and organic layers (M.-H. Lu and J. C. Sturm, J. Appl. Phys. 91, 595 (2002)). However, making ultra high-efficiency devices by reclaiming lost light can be very difficult. To recover even a fraction of light lost to waveguiding modes the device architecture can be very complex.

For the active matrix bottom emitting display, which uses switching elements of thin film transistors, the transistors are fabricated on glass substrates. Consequently the open area available for the light to emerge is reduced due to the presence of transistors. The ratio of open area to that of the entire device area is called the aperture ratio. Due to the reduction of the aperture ratio the display will run dim. To compensate for the reduced average brightness level, the drive current has to be increased subjecting the display to increased risk of operational degradation. To alleviate this problem the emitted light can be made to emerge through top surface. The aperture ratio will be significantly increased in contrast to bottom emitting devices for which the aperture ratio is typically about 30%. This type of device is called top-emitting or surface-emitting device. The surface-emitting device is of considerable interest in active matrix displays and in applications where the substrate needs to be made of a non-transparent material such as silicon. The top surface needs to be at least semitransparent in order to allow the light to emerge through the top surface.

Reversing the direction of emission in a bottom-emitting device in order to convert it to a top-emitting device is not trivial, particularly if the efficiency is to be preserved. This is because high transparency conducting cathode materials compatible with the Alq ETL are scarce. Compatible top electrode (cathode) materials for the Alq-based emissive/electron transport layer (EML/ETL) are low work function metals or alloys that are absorptive and reflective. Of the light that is emitted toward the semitransparent cathode, only a small fraction emits through the cathode; most is reflected back toward the transparent anode through which it emerges. Thinning down the cathode does not significantly increase top-emission, because to maintain the integrity of contact the cathode layer needs to be 8-10 nm thick to assure low voltage and contact stability. At that thickness the film has low transmission and high interface reflectivity. Through-substrate emission still prevails which is about 70 % of that from an identical device having a thick fully reflective cathode. Top-emission is weak, typically about 15 to 25%.

The top emission can be substantially increased if a reflector is used in the anode structure to reflect the light back toward the cathode. Sony Corporation in EP 1 154 676 A1 has used a reflector in conjunction with a buffer/hole injector. The reflecting metals were Pt, Au, Cr, W or the like - presumably a high work function material. The buffer layer is a layer for preventing leakage, and was made of m-MTDATA, which is also a hole-injecting layer. Lu and others ("High-efficiency top-emitting organic light-emitting devices", M.-H. Lu, M. S. Weaver, T. X. Zhou, M. Rothman, R. C. Kwong, M. Hack, and J. J. Brown, Appl. Phys. Lett. 81, 3921 (2002)) disclosed a top emitting OLED having an Ag/16 nm ITO anode and a Ca (20nm)/ITO (80 nm) cathode. The emissive medium, a 30 nm thick CBP layer doped with a 6 w% of Ir (ppy)₃ yielded an efficiency of about 20 cd/A which was about 15% higher than that of an equivalent bottom emitter having an ITO anode and a fully reflective LiF/A1 cathode. Both types of the devices used CuPc as the hole injector. They have used ITO over Ag and further used a CuPc hole-injecting layer presumably to have good hole injecting properties. These layers have reduced the anode reflectivity.
It is therefore an object of the present invention to provide a bottom-emitting OLED, the performance of which would exceed that of a conventional bottom-emitting OLED;
It is another object of the present invention to provide highly efficient top-emitting OLEDs;
It is another object of the present invention to use metal instead of ITO as the anode material, as metal anodes are more conducting and easier to fabricate than an ITO anode;
It is another object of the present invention to make use of an ultrathin hole-injecting layer on high-reflectivity anodes to preserve the anode reflectivity and to improve top-emission;

It is yet another object of the present invention is to achieve the objects without introducing complexity in the process or without major alteration of the device structure.

These objects are achieved in a bottom-emitting OLED device, comprising:
(a) a transparent substrate;
(b) a reflective, weakly absorbing, and conductive anode layer including a metal or metal alloy or both formed over the substrate;
(c) a hole-injection layer deposited over the reflective, weakly absorbing, and conductive anode layer;
(d) a plurality of organic layers formed over the hole-injection layer and including an emissive layer having electroluminescent material and an electron transport layer disposed over the emissive layer;
(e) a reflective and conductive cathode including a metal or metal alloy or both provided over the electron transport layer; and
(f) the transparency and reflectivity of the anode structure and reflectivity of cathode structure, the thickness of the organic layers between the electrodes, being selected to change the internal reflection of light to thereby improve the emission and obtain through- substrate luminance exceeding that of an optimized control device not having the reflective, weakly absorbing, and conductive anode.

These objects are further achieved in a top-emitting OLED device, comprising:
(a) a transparent or opaque substrate;
(b) a reflective, substantially opaque and conductive anode layer including a metal or metal alloy or both formed over the substrate;
(c) a hole-injection layer deposited over the reflective, substantially opaque and conductive anode layer;
(d) a plurality of organic layers formed over the hole-injection layer and including an emissive layer having electroluminescent material and an electron transport layer disposed over the emissive layer;
(e) a reflective, semitransparent and conductive cathode including a metal or metal alloy or both provided over the electron transport layer; and
(f) the reflectivity of the anode structure, transparency of the cathode and the thickness of the organic layers between the electrodes, being selected to change the internal reflection of light to thereby improve the emission through top electrode.

In accordance with the present invention it has been determined that the efficiency of bottom-emitting devices can be substantially improved over the conventional devices by including a weakly absorptive but reflective metallic layer and an ultrathin hole injection layer in the anode structure and by selecting the thickness of the weakly absorptive metal layer and the plurality of organic layers.

In accordance with the present invention it has been further determined that high efficiency of top-emission can be achieved by including a reflective metal, and an ultrathin hole injection layer in the anode structure and by selecting the thickness of the cathode layer and the plurality of organic layers.

An advantage of the present invention is that the emission is improved using low drive voltages.
FIG. 1 shows schematically the layer structure of a conventional bottom-emitting OLED device of prior art;
FIG. 2 shows schematically the layer structure of a bottom-emitting OLED device of the present invention;
FIG. 3 shows schematically the layer structure of a bottom-emitting OLED device of the present invention;
FIG. 4 shows schematically the layer structure of a bottom-emitting OLED device of the present invention;
FIG. 5 shows schematically the layer structure of a top-emitting OLED device of the present invention; and
FIG. 6 shows the on-axis luminance of a top-emitting OLED device having a Ag anode and a 11 nm thick MgAg cathode as a function of the NPB thickness determined by optical modeling.

Throughout the ensuing description acronyms are used to designate the names of the different organic layers and operating features of organic light-emitting devices. For reference they are listed in Table 1

**TABLE 1**

| | |
|---|---|
| OLED | Organic light-emitting device |
| ITO | Indium tin oxide |
| HIL | Hole- injection Layer |
| HTL | Hole-transport layer |
| EML | Emissive layer |
| ETL | Electron-transport layer |
| TEL | Transmission-enhancement layer |
| NPB | 4,4'-Bis[N-(1-naphthyl)-N-phenylamino]biphenyl (NPB) |
| Alq | Tris(8-hydroxyquinoline) aluminum |
| C545T | 10-(2-benzothiazolyl)-2,3,6,7-tetrahydro-1,1,7,7-tetramethyl-1H,5H,11H-[1]benzopyrano[6,7,8-ij]quinolizin-11-one |
| DCJTB | 4-(dicyanomethylene)-2-t-butyl-6-(1,1,7,7-tetramethyljulolidyl-9-enyl)-4H-pyran |
| MgAg | Mg(90 v %) Ag(10 v %) alloy |

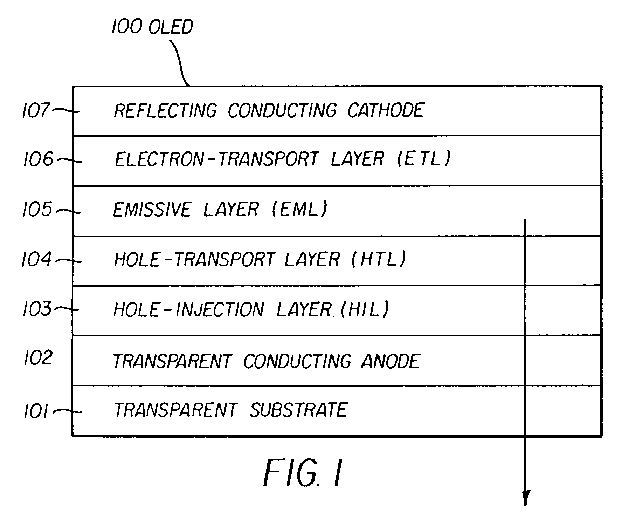

Turning now to FIG. 1, the OLED 100 is a prior art device includes a transparent substrate 101, a transparent anode 102, a hole-injection layer (HIL) 103, a hole-transport layer (HTL) 104, an emissive layer (EML) 105, an electron-transport layer (ETL) 106, and a reflecting cathode 107. The cathode 107 includes a metal of work function lower than about 4 eV. In operation, the anode 102 and the cathode 107 are connected to a voltage source and electrical current is passed through the organic layers, resulting in light emission or electroluminescence from the emissive layer 105. The intensity of generated light is dependent on the magnitude of the electrical current passed through the OLED 100, which in turn is dependent on the luminescent and electrical characteristics of the organic layers as well as the charge-injecting nature of the anode 102, hole-injection layer 103, and cathode 107. The emission viewable is further dependent on the transmittance of the substrate 101 and anode 102 and reflectance of the cathode 107 as well as the layer structure of the OLED 100.

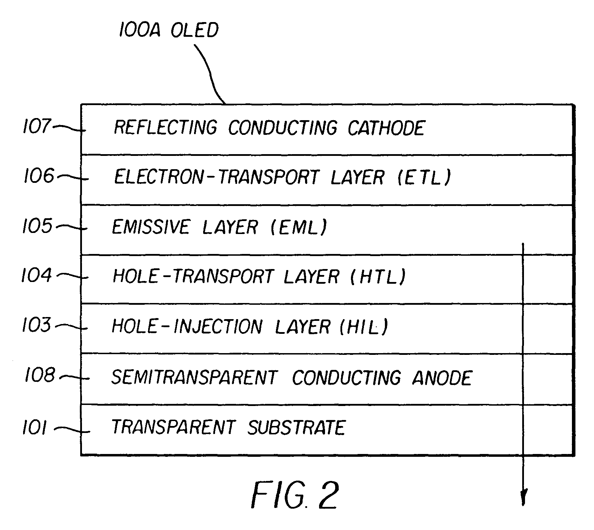

In FIG. 2 through FIG. 4, the OLED devices of the present invention are shown. In OLED 100A (FIG. 2) the anode includes a semitransparent metal layer 108 otherwise similar to prior art device OLED 100. When energized the OLED 100A emits light which, like the prior art device OLED 100, is viewable through substrate 101. However the thickness of the anode 108and organic layers are selected to maximize efficiency..

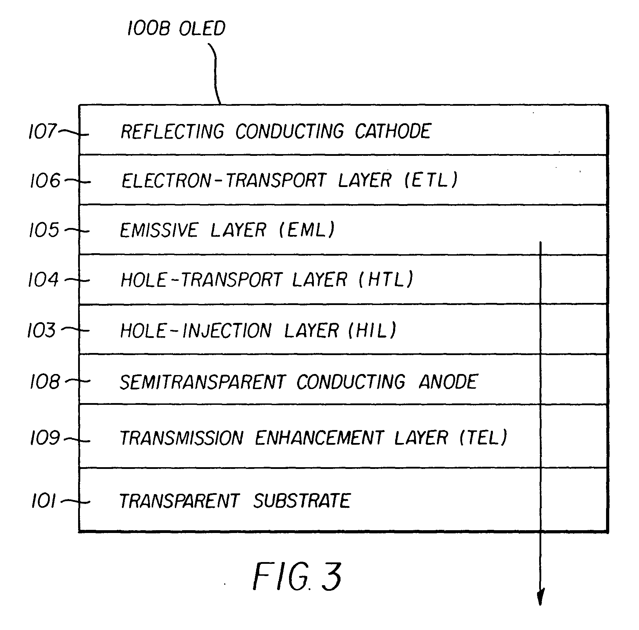

In OLED 100B (FIG. 3) a transmission enhancement layer (TEL) 109 is placed between the transparent substrate 101 and a semitransparent conducting reflecting anode 108 made of metal or metal alloy is provided to further enhance the emission through the substrate 101. The OLED 100B is otherwise similar to device OLED 100A.

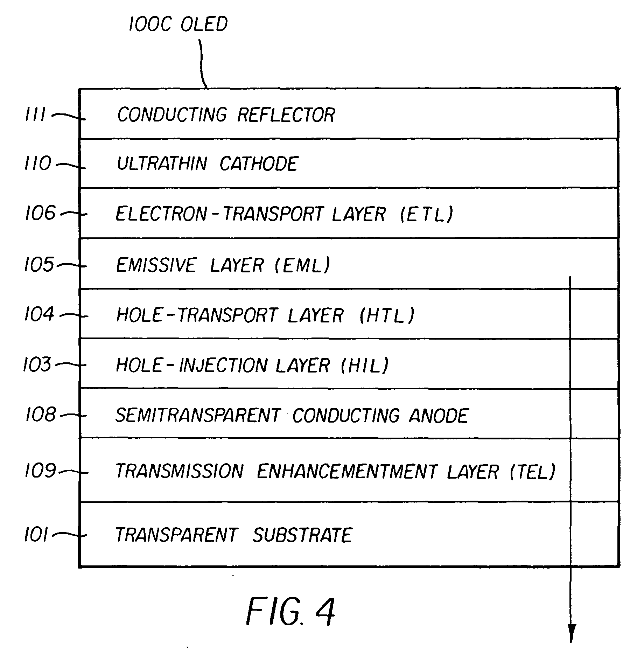

In OLED 100C (FIG. 4) a conducting reflector 111 is used regardless of the work function. The conducting reflector 111 is deposited on the ultrathin cathode 110, which is formed over the electron-transport layer 106. The OLED 100C is otherwise similar to OLED 100B.

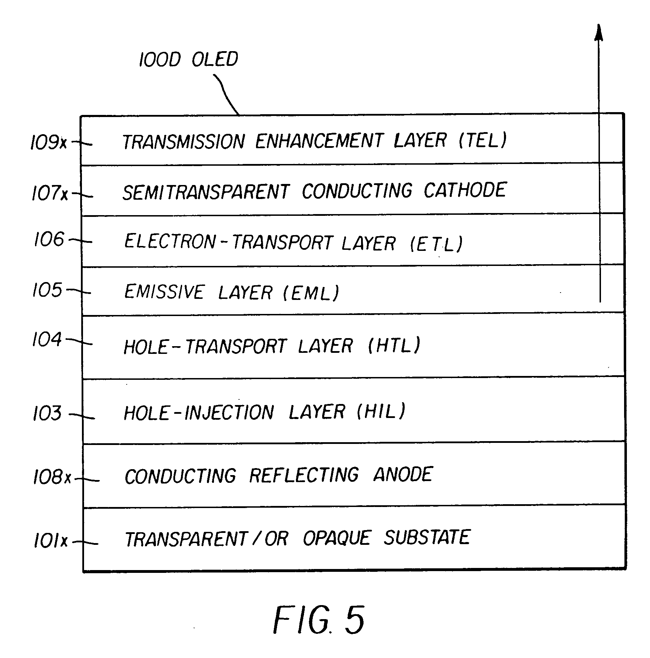

In OLED 100D (FIG. 5) light to passes through the semitransparent conducting cathode107x, and the transmission enhancement layer 109x. A conducting reflecting anode 108x is a fully reflective layer deposited over a transparent or opaque substrate 101x.

The composition and the function of the various layers constituting the OLED device are described as follows.

Substrate 101 may include glass, ceramic, or plastics. For devices emitting through substrate 101, the substrates should be as transparent as possible. Since the OLED device fabrication does not require high temperature process, any substrate 101 that can withstand process temperatures of the order of 100 °C is useful, which includes most thermal plastics. The substrate 101 may take the form of rigid plate, flexible sheet, or curved surfaces. Substrate 101 may include support with electronic backplane, and thus includes active-matrix substrates, which contain electronic addressing and switching elements. Active-matrix substrates may contain high temperature polysilicon thin-film-transistors, low temperature polysilicon thin-film-transistors or amorphous silicon thin film transistors. Those skilled in the art will appreciate that other circuit elements can be used to address and drive the OLED devices.

Anode 102 (FIG. 1) provides the function of injecting holes into the organic layer when a positive potential relative to the cathode 107 is applied to the OLED 100. It has been shown, for example, in commonly assigned US-A-4,720,432, that indium tin oxide (ITO) forms an efficient anode because it has a relatively high work function. Since the ITO film itself is transparent and conducting, commercially available ITO-coated glass provides an excellent support for the fabrication of OLED 100 type devices (FIG. 1). OLED 100A type devices (FIG. 2) use a conducting and semitransparent metal/alloy layer as the anode 108 which is deposited on the transparent substrate 101. The anode 108 can be deposited by conventional deposition processes and may also be compatible with the manufacturing process for OLED 100. This anode 108 may or may not need an overlying hole-injecting layer 103.

Hole-injection layer 103 provides the function of increasing the efficiency of the hole-injection from the anode 102 (FIG. 1) or anode 108 of (FIG. 2) into the hole-transport layer. It has been shown, for example in commonly assigned US-A-4,885,211, that a porphorinic or phthalocyanine compound is useful as a hole injection layer 103 to the hole-transport layer 104 of the prior art type device (FIG. 1), resulting in increased luminance efficiency and operational stability. Other preferred hole-injection materials include CFₓ, which is a fluorinated polymer deposited by plasma-assisted vapor deposition, wherein x is less than or equal to 2 and greater than 0. The method of preparation and the characteristics of CFₓ have been disclosed in commonly assigned US-A-6,208,077. Other materials can also be used as hole injectors. These include oxides of Mo, V or Ru. A layer of these materials each about 30 nm thick on 120 nm thick ITO have been found useful as a hole injector to TPD, an hole-transport layer ("Metal oxides as a hole-injecting layer for an organic electroluminescent device", S. Tokito, K. Noda and Y. Taga, J. Phys. D; Appl. Phys. 29, 2750 (1996)). In accordance with the present invention CFₓ and MoOₓ (x <3.0) were found to provide efficient hole injection from the metal anode 108 or anode 108x to the hole-transport layer 104 of FIG. 2, FIG. 3, or FIG. 4 or FIG. 5. MoOₓ layer is prepared by vacuum evaporation of MoO₃ and the deposited film may be non-stoichiometric. Other hole injectors for metal anodes may include ITO, IZO, Pr₂O₃, TeO₂, CuPc, or SiO₂.

Hole-transport layer 104 provides the function of transporting holes to the emissive layer 105. Hole-transport materials include various classes of aromatic amines as disclosed in commonly assigned US-A-4,720,432. A preferred class of hole-transport materials includes the tetraaryldiamines of formula (I). 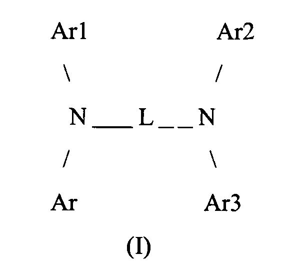 wherein:
Ar, Ar1, Ar2 and Ar3 are independently selected from among phenyl, biphenyl and naphthyl moieties;
L is a divalent naphthylene moiety or dₙ;
d is a phenylene moiety;
n is an integer of from 1 to 4; and
at least one of Ar, Ar1, Ar2 and Ar3 is a naphthyl moiety.

Useful selected (fused aromatic ring containing) aromatic tertiary amines are the following:
4,4'-Bis[N-(1-naphthyl)-N-phenylamino]biphenyl (NPB)
4,4"-Bis[N-(1-naphthyl)-N-phenylamino]-p-terphenyl
4,4'-Bis[N-(2-naphthyl)-N-phenylamino]biphenyl
1,5-Bis[N-(1-naphthyl)-N-phenylamino]naphthalene
4,4'-Bis[N-(2-pyrenyl)-N-phenylamino]bi-phenyl
4,4'-Bis[N-(2-perylenyl)-N-phenylamino]biphenyl
2,6-Bis(di-p-tolylamino)naphthalene
2,6-Bis[di-(1-naphtyl)amino]naphthalene

Emissive layer 105 (FIGS. 1-5) provides the function of light emission produced as a result of recombination of holes and electrons in this layer. A preferred embodiment of the emissive layer 105 includes a host material doped with one or more fluorescent dyes. Using this host-dopant composition, highly efficient OLED devices can be constructed. Simultaneously, the color of the EL devices can be tuned by using fluorescent dyes of different emission wavelengths in a common host material. Tang and others in commonly assigned US-A-4,769,292 has described this dopant scheme in considerable detail for OLED devices using Alq as the host material. As set forth in the Tang and others commonly assigned US-A-4,769,292, the emissive layer can contain a green light-emitting doped material, a blue light-emitting doped material, or a red light-emitting doped material.

Preferred host materials include the class of 8-quinolinol metal chelate compounds with the chelating metals being Al, Mg, Li, Zn, for example. Another preferred class of host materials includes anthracene derivatives such as 9,10 dinaphthyl anthracene; 9,10 dianthryl anthracene; and alkyl substituted 9,10 dinaphthyl anthracene, as disclosed in Shi and others commonly assigned US-A-5,935,721.

Dopant materials include most fluorescent and phorphorescent dyes and pigments. Preferred dopant materials include coumarins such as coumarin 6, dicyanomethylenepyrans such as 4-dicyanomethylene-4H pyrans, as disclosed in Tang and others commonly assigned US-A-4,769,292 and in Chen and others in commonly assigned US-A-6,020,078.

Electron-transport layer 106 (FIGS. 1-5) provides the function of delivering electrons injected from the cathode to emissive layer 105 (FIGS. 1-5). Useful materials include Alq, benzazoles, as disclosed in commonly assigned Shi and others commonly assigned US-A-5,645,948.

Cathode 107 (FIGS. 1-3) is typically a conducting and fully reflective thin film, about 50 to 500 nm thick, and comprised of materials including alloys capable of efficiently injecting electrons into the electron-transport layer 106 (FIGS. 1-3). Mg and Li containing alloys are generally used because they have low work functions and make efficient electron-injecting contacts to Alq electron-transport layer 106. Other materials with work-functions of <4.0 eV can also be used as the electron injectors. These include metal or metal alloys including alloys of Ag or Al with Mg, alkali metals, alkali earth metals, or Mn. The cathode 107x is generally vapor deposited on electron-transport layer 106 (FIGS. 1-3). Cathode 107x (FIG. 5) is a semitransparent film about 4 to 50 nm thick also vapor deposited and includes a low work function (<4 eV) metal and metal alloys including alloys of Ag or Al with Mg, alkali metals, alkali earth metals, or Mn.

Anode 108 (FIGS. 2-4) is a reflective, weakly absorbing, and conductive film and comprised of materials including alloys having significant transmittance at the emission wavelength. Such metals include Ag, Al, Mg, Zn, Rh, Ru, Ir, Au, Cu, Pd, Ni, Cr, Pt, Co, Te, or Mo, or alloys or mixtures thereof. By weakly absorbing it is meant that the absorption of a film on glass is less than 30%. The reflectivity of such layers can be about 30% or greater. Depending on the metals the thickness of the layer should be greater than about 4 nm but less than about 50 nm. Anode 108x (FIG. 5) is a conducting and fully reflecting layer, 50 to 500 nm thick and includes Ag, Al, Mg, Zn, Rh, Ru, Ir, Au, Cu, Pd, Ni, Cr, Pt, Co, Te, Mo, Hf, Fe, Mn, Nb, Ge, Os, Ti, V, or W, or alloys or mixtures thereof.

Transmission enhancement layer 109 (FIGS. 3 and 4) is a highly transmissive film inserted between the substrate 101 and the semitransparent anode 108 to further increase the emission through substrate 101. The transmission enhancement layer 109x (FIG. 5) is also a highly transmissive film deposited over the reflecting conducting cathode 107x to further increase the emission through semitransparent reflecting conducting cathode 107x. The transmission enhancement layers 109 and 109x include conductive or nonconductive materials including but not limited to: ITO, indium zinc oxide (IZO), tin oxide (TO), antimony-doped tin oxide (ATO), fluorine-doped tin oxide (FTO), indium oxide (IO), zinc oxide (ZO), cadmium stannate (CTO), cadmium oxide, phosphorus-doped TO, and aluminum-doped ZO, MgO, MoOₓ, SiO₂ Al₂O₃ TiO₂, ZrO₂, SiN, AIN, TiN, ZrN, SiC, or Al₄C₃, or mixtures thereof. Depending on the optical indices of the material the thickness of transmission enhancement layers 109 or 109x can range from 20 nm to 150 nm.

An ultrathin cathode 110 (FIG. 4) is effectively a transparent electron injecting layer formed over the electron-transport layer 106. Such cathodes 110 are prepared by depositing an ultrathin layer of an alkali metal or alkali earth metal or combinations thereof. The cathode 110 can also be prepared by depositing a compound of the metals and an activator metal like Al, Mg and so forth. A bilayer structure, including thin Al, Mg, or MgAg layer on LiF, each about 1 nm thick, provides efficient electron injection to electron-transport layer 106. Such a cathode 110 allows the use of any metal/alloy regardless of the work-function as the top electrode.

The reflector 111 (FIG. 4) is typically a reflective layer of high reflectivity metal that may include but is not limited to Au, Ag, Cu, Al, or alloys thereof. The reflector reflects the light that emits toward the cathode and redirects it toward the substrate. Although a high reflectivity reflector helps to remarkably enhance emission through substrate, other lower reflectivity metals such as Mg, Zn, Ni, Pd, or Pt or alloys or mixtures thereof may be useful. The thickness of the reflector is chosen large enough to provide maximum reflectivity.

The organic materials mentioned above are suitably deposited by evaporation in high vacuum. The metal/alloy layers are also vapor deposited although it is possible to use sputtering deposition if the device architecture includes a buffer (P.K. Raychaudhuri and J.K. Madathil, "Fabrication of Sputtered Cathodes for Organic Light-Emitting Diodes Using Transparent Buffer", Proceedings of the 7th Asian Symposium on Information Display (Sept 2 -4, Singapore a) Digest, paper 50; Vol. 32, pp. 55-58, 2001).

Most OLED devices are sensitive to moisture or oxygen or both, so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in US-A-6,226,890. In addition, barrier layers such as SiOₓ, Teflon, and alternating inorganic/polymeric layers are known in the art for encapsulation.

OLED devices of this invention can employ various well-known optical effects in order to enhance their properties if desired. This includes optimizing layer thicknesses to yield maximum light transmission, replacing reflective electrodes with light-absorbing electrodes to enhance contrast, providing anti-glare or anti-reflection coatings over the display, providing a polarizing medium over the display, or providing colored, neutral density, or color conversion filters over the display. Filters, polarizers, and anti-glare or anti-reflection coatings may be specifically provided over the cover or as part of the cover.

### EXAMPLES:

Prior art devices were fabricated using glass substrates having a commercial grade 42-nm thick, 70-ohm/sq patterned ITO layer. After routine cleaning, a layer of 1-nm thick CFₓ HIL was deposited on the ITO surface by decomposing CHF₃ gas in RF plasma. The substrates for the devices of the present invention were glass plates upon which was deposited a weakly absorbing metal layer by sputtering in Ar containing atmosphere. These metallized glass substrates were also coated either with the said CFₓ hole injection layer or with a vapor deposited MoOₓ hole injection layer. The substrates were then transferred to a vacuum coater operating at ∼1 x 10⁻⁶ Torr, where the organic stack consisting of HTL, EML, ETL were deposited in sequence. A cathode layer of MgAg or of LiF/ MgAg was then deposited through a square mask, which defined an active area of 0.1 cm² for the device. Finally, the devices were hermetically encapsulated in a glove box filled with dry nitrogen. The luminance of the devices was determined using a Photo Research PR650 spectroradiometer as a function of current. The drive voltage and luminance given here are those obtained when a current corresponding to 20 mA/cm² was passed through the devices and luminance being determined in the direction normal to the device surface. The voltage drop caused by series resistance of the ITO layer or the semitransparent anode layer 108 or 108x was subtracted from the measured drive voltage in order to compare devices on the basis of their "true" drive voltage.

### Example 1

A prior art device was made using ITO as the transparent anode, CFₓ as the HIL, Alq as the EML/ETL and a LiF/MgAg layer as the cathode (top electrode). The top electrode comprising 90% Mg and 10 % Ag by volume (hereafter MgAg) is 100 nm thick, fully reflective and opaque. The device is optimized for maximization of bottom emission. The device has the following layer structure:
Glass(1.1 mm)/ITO(42nm)/CFₓ(1nm)/NPB(105nm)/Alq(60nm)/LiF(0.5 nm)/MgAg(100 nm)

The light emerges through substrate. At a drive current corresponding to 20 mA/cm² the drive voltage was 7.8 V and the emission was 641 cd/m². The efficiency of the device is 3.2 cd/A. The peak emission wavelength is 525 nm.

### Example 2

A device according to the present invention was made using a semitransparent Ag anode, MoOₓ as the HIL, Alq as the EML/ETL, and a LiF/MgAg layer as the cathode (top electrode). The MgAg layer is fully reflective and opaque. The device is optimized for maximization of bottom emission. The device has the following layer structure:
Glass(1.1 mm)/Ag(20 nm)/ MoOₓ(2nm)/NPB(40 nm)/Alq(60nm)/LiF(0.5 nm)/MgAg(100 nm)

The light emerges through substrate. At a drive current corresponding to 20 mA/cm² the drive voltage was 6.9 V and the bottom emission was 1346 cd/m². The efficiency of the device is 6.7 cd/A. The peak emission wavelength is 525 nm.

Examples 1 and 2 show that the device of the present invention is more than twice as efficient as the prior art device and that the emission wavelength remains unchanged.

### Example 3. (comparative)

A prior art device (3F) having a 42 nm thick ITO anode, and a series of devices of present invention (devices 3A, 3B, 3C, 3D and 3E) each having a semitransparent Ag anode layer were made. The device structure in each case was optimized for maximization of bottom emission by selecting the NPB layer thickness. The hole-injection layer for each of the devices was a 1 nm thick CFₓ layer. All devices also used 30 nm thick Alq doped with 1% C545T as the emitter, 30 nm thick undoped Alq as the electron-transport layer, and 100 nm thick MgAg layer as the cathode. The results are tabulated in Table 2.

**TABLE 2**

| Device ID | Ag Thickness (nm) | NPB Thickness (nm) | Drive Voltage (V) | Luminance (cd/m²) | Efficiency (cd/A) |
|---|---|---|---|---|---|
| 3F | 0 | 105 | 6.4 | 2185 | 10.9 |
| 3E | 10 | 45 | 6.5 | 2520 | 12.6 |
| 3D | 20 | 45 | 5.7 | 4148 | 20.7 |
| 3C | 30 | 45 | 5.6 | 3255 | 16.3 |
| 3B | 40 | 45 | 5.7 | 2074 | 10.4 |
| 3A | 50 | 45 | 5.8 | 1134 | 5.7 |

The results of Example 3 show that devices of the present invention having a semitransparent Ag anode in the thickness range between 10 nm and 30 nm (devices 3E, 3D and 3C) exhibit luminance that is greater than that of the prior art device (3F). The efficiency of the device having the 20nm Ag anode is about 2 times the efficiency of the prior art device (3F).

### Example 4 (comparative)

A prior art device (4F) having a 42 nm thick ITO anode, and a series of devices of present invention (devices 4A, 4B, 4C, 4D and 4E) each having a semitransparent Au anode layer were made. The device structure in each case was optimized for maximization of bottom emission by selecting the NPB layer thickness. The hole-injection layer for each of the devices was a 1 nm thick CFₓ layer. All devices also used 30 nm thick Alq doped with 1% DCJTB as the emitter, 30 nm thick undoped Alq as the electron-transport layer, and 100 nm thick MgAg layer as the cathode. The results are tabulated in Table 3.

**TABLE 3**

| Device ID | Au Thickness (nm) | NPB Thickness (nm) | Drive Voltage (V) | Luminance (cd/m²) | Efficiency (cd/A) |
|---|---|---|---|---|---|
| 4F | 0 | 110 | 6.7 | 469 | 2.3 |
| 4E | 15 | 60 | 6.7 | 767 | 3.8 |
| 4D | 20 | 60 | 6.9 | 868 | 4.3 |
| 4C | 30 | 60 | 6.8 | 668 | 3.3 |
| 4B | 40 | 60 | 6.7 | 485 | 2.4 |
| 4A | 50 | 60 | 6.7 | 325 | 1.6 |

The results of Example 4 show that devices of the present invention having a semitransparent Au anode in the thickness range between 15 nm and 40 nm (devices 4E, 4D, 4C and 4B) exhibit emission that is greater than that of the prior art device (4F). The efficiency of the device (4D) having the 20nm Au anode is about 2 times the efficiency of the prior art device (4F).

### Example 5

Optical modeling was performed on a prior art device structure: device 5A -- Glass (1.1 mm)/ ITO(42nm)/ NPB(105 nm)/Alq(60nm)/ MgAg(100 nm) and a device of the present invention: device 5B-- Glass (1.1 mm)/ Mo(5 nm)/ NPB(50 nm)/Alq (60nm)/ MgAg(100 nm). For optical modeling the presence in the stack of ultrathin layer of CFₓ or MoOₓ have been neglected. The output of the device 5B was found to be about 92% when compared with that of the device 5A. But when a transparent TEL with index n=2.7 was interposed between the glass substrate and the Mo anode, and the layer structure was readjusted to have the device 5C having the structure- Glass(1.1 mm)/TEL(49.1 nm)/Mo(5 nm)/ NPB(67 nm)/Alq(64.6 nm)/ MgAg(100 nm) the output of the device 5C is predicted to be about 1.5 times that of the prior art device,5A. Since device 5C has only slightly thicker Alq and NPB the drive voltage increase would be negligible. Surface resistance of a layer of 5 nm thick Mo is estimated to be 11 ohm/sq which is lower than the ITO layer used in making the prior art device. ***Example 6 (comparative)***

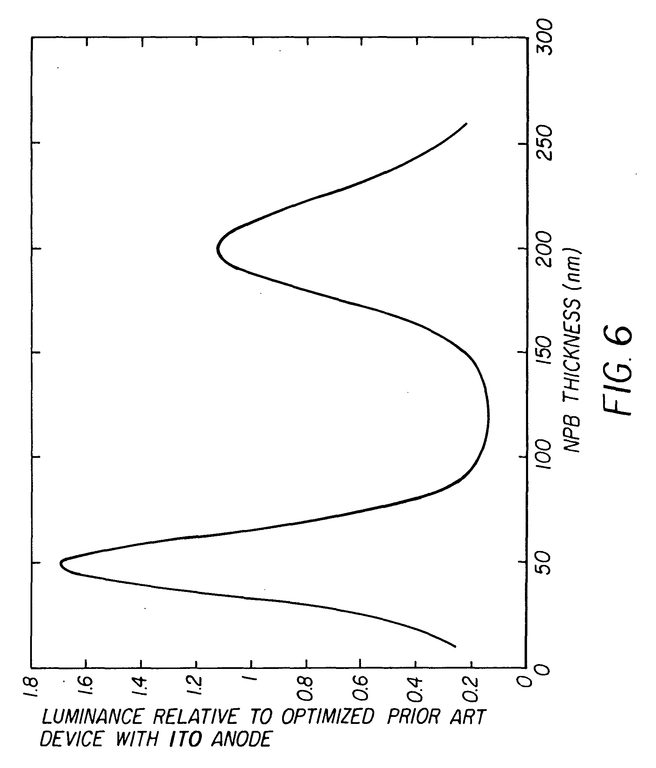

Optical modeling was performed on a prior art device structure: device 6A -- Glass(1.1 mm)/ ITO(42nm)/ NPB(105 nm)/Alq(60nm)/ MgAg(100 nm) and a series of devices of the present invention having varying thickness of the HTL layer: Glass(1.1 mm)/Ag(20 nm)/NPB(vary)/Alq (60nm)/MgAg(100 nm). For optical modeling the presence in the stack of ultrathin layer of CFₓ or MoOₓ have been neglected. The results show that on-axis maximum luminance occurs at 50 nm (1^{st} maximum) and at 200 nm (2^{nd} maximum), as shown in FIG. 6. At the location of the first maximum the luminance of the device of the present invention is about 1.7 times that of the optimized bottom-emitting prior art device 6A. This is in fair agreement with the experimental data presented in the above examples. With a TEL layer the OLED of the present invention in the thickness range 20 nm to 80 nm or 180 nm to 230 nm of NPB is predicted to exceed the luminance of the prior art device. The total thickness of the organic layers between electrodes for high efficiency bottom emitters are either 80 nm to 140 nm or 240 nm to 290 nm for the first or second maximum, respectively.

### Example 7

A series of top emitters of the present invention (devices 7A, 7B, 7C, 7D, 7E and 7F) each having a 60 nm thick Ag anode, a semitransparent cathode, and varying NPB layer thickness was made. The HIL for each of the devices was a 1 nm thick CFₓ. For all devices used were 30 nm thick Alq doped with 1% C545T as the EML, 30 nm thick undoped Alq as the ETL, and 14 nm thick semitransparent MgAg layer as the cathode. The devices do not have a TEL but are otherwise similar to the device of FIG. 5. The results are tabulated in Table 4.

**TABLE 4**

| Device ID | NPB Thickness (nm) | Drive Voltage (V) | Luminance (cd/m²) | Efficiency (cd/A) |
|---|---|---|---|---|
| 7A | 10 | 5.5 | 218 | 1.1 |
| 7B | 30 | 6.5 | 922 | 4.6 |
| 7C | 40 | 5.5 | 2064 | 10.3 |
| 7D | 45 | 5.5 | 2768 | 13.8 |
| 7E | 50 | 5.6 | 3117 | 15.6 |
| 7F | 70 | 5.7 | 1388 | 6.9 |

The results of Example 7 show that for devices of the present invention having a semitransparent MgAg cathode, the luminance is maximized when the thickness of the NPB layer is 50 nm. A simulation similar to Example 6 predicts that the first maximum in on-axis luminance occurs at the NPB thickness of 45nm and that the second maximum occurs at the NPB thickness of 180 nm. The ideal thickness of the organic medium for maximization of top-emission is thus either 105 nm or 240 nm. Devices with high efficiency can be made in the NPB thickness range between 30 nm to 80 nm or 160 nm to 230 nm. This leads to total organic layer thickness 90 nm to 140nm or 220 nm to 290 nm.

### Example 8

Several top-emitters of the present invention were made using various reflective anodes but all having a common 14 nm MgAg cathode, and common organic layers-50 nm NPB hole-transport layer and 60 nm Alq EML/ETL. The reflectors used were fully reflective films of Ag, Pd and Mo. The reflectivities of fully reflective film in air at ∼525 nm, taken from the literature, are also tabulated in Table 5. The hole-injection layer for each of the devices was a MoOₓ film, 1 nm thick. The device does not have a TEL. The device performance is tabulated in Table 5.

**TABLE 5**

| Device ID | Reflecting metal | Reflectance (%) | Drive voltage (V) | Efficiency (cd/A) |
|---|---|---|---|---|
| 8A | Ag | 92 | 5.8 | 5.2 |
| 8B | Pd | 69 | 5.9 | 2.2 |
| 8C | Mo | 59 | 6.1 | 1.1 |

The results of Example 8 show that the top emission is an increasing function of anode reflectivity. But the output is not simply proportional to anode reflectivity; rather, it rises significantly more rapidly in the high reflectivity range. If the advantage of top-emitter over bottom-emitter with respect to aperture ratio is considered then even the top emitter having a Mo anode is expected to outperform a bottom emitter having an ITO anode.

### Example 9

Two top-emitting devices of the present invention were made each having a 72 nm thick Ag anode, 2.5 nm thick MoOₓ HIL, 45 nm thick NPB HTL and 60 nm Alq EML/ETL and 0.5 nm LiF/ 14 nm MgAg cathode. The device 9A does not have a TEL. On the cathode of the device 9B was deposited a 85 nm Alq layer as the TEL. At a drive current corresponding to 20 mA/cm² the device 9A has a drive voltage of 7.3 V and a luminance of 1260 cd/m². Under similar condition the device 9B has a drive voltage of 7.1 V and a luminance of 1630 cd/m^{2.} The 85 nm Alq layer has acted as a TEL. The improvement due to the TEL is about 29%.

It is seen from all these examples that when OLED devices are made using two reflective electrodes, that is, making a microcavity device, the on-axis emission through the substrate can be greater than that of a prior art control device that has a low-reflectivity, highly-transparent ITO anode. However, the device architecture has to be altered. The emission from a microcavity is strongly directed along the optical axis (normal to the emitting plane). For the device of the present invention when optimized, the loss of light in OLED devices 100A, 100B or 100C (FIGS. 2-4) due to absorption in the anode can be more than compensated by the gain due to the microcavity effect.

An optical microcavity OLED somewhat similar to that of the present invention is reported in the literature ("Control of emission characteristics in organic thin-film electro luminescent devices using an optical-microcavity structure" N. Takada, T. Tsutsui, and S. Saito, Appl. Phys. Lett. 63, 2032 (1993)). A microcavity structure which comprised a reflective, semitransparent, 36 nm thick Ag anode and a reflective 250 nm thick MgAg cathode was fabricated. A device without the microcavity structure with a transparent ITO anode was also prepared for reference. These two devices were made on one support and had common organic layers and cathode. The microcavity device did not exhibit enhancement of bottom emission over that of the non-microcavity device. The microcavity device characteristically exhibited angular dependence of emission and emission peak shift with viewing angle. However, the emission from the microcavity device was weaker than that of the non-microcavity device. The thick anode, the non-optimized device structure, and, more importantly, the absence of a hole-injecting layer may have resulted in an inefficient device. Optimization of these three aspects is the most distinguishing feature that is incorporated in the present invention.

Other features of the invention are included below.

The bottom-emitting OLED device wherein the plurality of organic layers includes a hole-transport layer disposed between the hole injection layer and the emissive layer.

The bottom-emitting OLED device wherein the reflective, weakly absorbing, and conductive anode includes Ag, Al, Mg, Zn, Rh, Ru, Ir, Au, Cu, Pd, Ni, Cr, Pt, Co, Te, or Mo or alloys or mixtures thereof.

The bottom-emitting OLED device wherein the reflective, weakly absorbing, and conductive anode layer has an absorbance of 30% or less.

The bottom-emitting OLED device wherein the reflective and conductive cathode includes metal or metal alloys having a work function selected to be about 4.0 eV or less.

The bottom-emitting OLED device wherein the metal or metal alloys include alloys of Ag or Al with Mg, alkali metals, alkali earth metals, or Mn.

The bottom-emitting OLED device wherein the hole injection layer includes CFₓ, ITO, IZO, Pr₂O₃, TeO₂, CuPc, SiO₂, VOₓ, MoOₓ, or mixtures thereof.

The bottom-emitting OLED device wherein the hole transport layer includes NPB.

The bottom-emitting OLED device wherein the emissive layer includes Alq.

The bottom-emitting OLED device wherein the electron-transport layer includes Alq.

The bottom-emitting OLED device wherein the emissive layer contains fluorescent or phosphorescent dopants.

The bottom-emitting OLED device wherein the thickness of the hole-transport layer is in the range of 20 nm to 80 nm or 180 nm to 230 nm.

The bottom-emitting OLED device wherein the thickness of the anode layer is in a range of from 4 nm to 50 nm.

The bottom-emitting OLED device wherein the thickness of the cathode layer is in a range of from 50 nm to 500 nm.

The bottom-emitting OLED device which includes an ultrathin cathode over the electron transport layer.

The bottom-emitting OLED device which further includes a highly reflective, substantially opaque metal/alloy over the ultrathin cathode.

The bottom-emitting OLED device wherein the highly reflective, substantially opaque metals include Ag, Al, Mg, Zn, Au or Cu or alloys or mixtures thereof.

The top-emitting OLED device wherein the plurality of organic layers includes a hole-transport layer disposed between the hole injection layer and the emissive layer.

The top-emitting OLED device wherein the reflective, substantially opaque and conductive anode includes Ag, Al, Mg, Zn, Rh, Ru, Ir, Au, Cu, Pd, Ni, Cr, Pt, Co, Te, Mo, Hf, Fe, Mn, Nb, Ge, Os, Ti, V or W, or alloys or mixtures thereof.

The top-emitting OLED device wherein the reflective, semitransparent and conductive cathode has an absorbance of 30% or less.

The top-emitting OLED device wherein the thickness of the TEL ranges from 20 nm to 150 nm.

The top-emitting OLED device wherein the hole transport layer includes NPB.

The top-emitting OLED device wherein the emissive layer includes Alq.

The top-emitting OLED device wherein the electron-transport layer includes Alq.

The top-emitting OLED device wherein the emissive layer contains fluorescent or phosphorescent dopants.

The top-emitting OLED device wherein the thickness of the hole-transport layer is 30 to 80 nm or 160 to 230 nm.

The top-emitting OLED device wherein the total thickness of organic layers is 90 to 140 nm or 220 to 290 nm.

The top-emitting OLED device wherein the thickness of the anode layer is in a range of from 50 nm to 500 nm

The top-emitting OLED device wherein the thickness of the cathode layer is in a range of from 5 nm to 50 nm.

The top-emitting OLED device which includes an ultrathin cathode over the electron transport layer.

The top-emitting OLED device which further includes a highly reflective, semitransparent metal/alloy over the ultrathin cathode.

The top-emitting OLED device wherein the highly reflective, semitransparent metals include Ag, Al, Mg, Zn, Au or Cu or alloys or mixtures thereof.

## Claims

1. A bottom-emitting OLED device, comprising:
(a) a transparent substrate;
(b) a reflective, weakly absorbing, and conductive anode layer including a metal or metal alloy or both formed over the substrate;
(c) a hole-injection layer deposited over the reflective, weakly absorbing, and conductive anode layer;
(d) a plurality of organic layers formed over the hole-injection layer and including an emissive layer having electroluminescent material and an electron transport layer disposed over the emissive layer;
(e) a reflective and conductive cathode including a metal or metal alloy or both provided over the electron transport layer; and
(f) the transparency and reflectivity of the anode structure, reflectivity of cathode structure, and the thickness of the organic layers between the electrodes being selected to change the internal reflection of light to thereby improve the emission and obtain through-substrate exceeding that of an optimized control device not having the reflective, weakly absorbing, and conductive anode.

2. The bottom-emitting OLED device of claim 1 which further includes a transmission enhancement layer (TEL) between the transparent substrate and the reflective, weakly absorbing, and conductive anode layer to further improve the amount of light which passes through the anode.

3. The bottom-emitting OLED device of claim 2 wherein the TEL includes ITO, MgO, MoOₓ, SnO₂, TiO₂, Al₂O₃, SiO₂, ZnO, ZrO₂, Alq, NPB, SiN, AIN, TiN, SiC, Al₄C₃, or mixtures thereof.

4. The bottom-emitting OLED device of claim 3 wherein the thickness of the TEL ranges from 20 nm to 150 nm.

5. The bottom-emitting OLED device of claim 1 wherein the combined thickness of all layers between the anode and cathode is in the range of 90 nm to 150 nm or 230 nm to 330 nm.

6. A top-emitting OLED device, comprising:
(a) a transparent or opaque substrate;
(b) a reflective, substantially opaque, and conductive anode layer including a metal or metal alloy or both formed over the substrate;
(c) a hole-injection layer deposited over the reflective, substantially opaque, and conductive anode layer;
(d) a plurality of organic layers formed over the hole-injection layer and including an emissive layer having electroluminescent material and an electron transport layer disposed over the emissive layer;
(e) a reflective, semitransparent, and conductive cathode including a metal or metal alloy or both provided over the electron transport layer; and
(f) the reflectivity of the anode structure, the transparency of the cathode, and the thickness of the organic layers between the electrodes being selected to change the internal reflection of light to thereby improve the emission through the top electrode.

7. The top-emitting OLED device of claim 6 which further includes a transmission enhancement layer (TEL) over the reflective, semitransparent and conductive cathode to further improve the amount of light which passes through the cathode .

8. The top-emitting OLED device of claim 6 wherein the reflective, substantially opaque, and conductive anode layer includes metal or metal alloys having a work function selected to be greater than about 4.0 eV.

9. The top-emitting OLED device of claim 6 wherein the hole injection layer includes CFₓ, ITO, IZO, Pr₂O₃, TeO₂, CuPc, SiO₂, VOₓ, MoOₓ, or mixtures thereof.

10. The top-emitting OLED device of claim 7 wherein the TEL includes ITO, MgO, MoOₓ, SnO₂, TiO₂, Al₂O₃, SiO₂, ZnO, ZrO₂ Alq, NPB, SiN, AlN, TiN, SiC or Al₄C₃ or mixtures thereof.
